# FASCICULE DE BREVET EUROPEEN

(11) **EP 2 802 680 B1**
(45) Date de publication et mention de la délivrance du brevet: **30.03.2016**
(21) Numéro de dépôt: 13704147.1
(22) Date de dépôt: 11.01.2013
(51) Int. Cl.: C23C 16/26, C23C 30/00, C01B 31/02, B82Y 30/00, B82Y 40/00

(54) **RENFORCEMENT DE L'ADHÉSION OU DE LA FIXATION DE NANOTUBES DE CARBONE À LA SURFACE D'UN MATÉRIAU PAR UNE COUCHE DE CARBONE**
VERBESSERUNG DER ADHÄSION ODER DES ANHAFTENS VON KOHLENSTOFFNANORÖHRCHEN AUF DER OBERFLÄCHE EINES MATERIALS ÜBER EINE KOHLENSTOFFSCHICHT
ENHANCING THE ADHESION OR ATTACHMENT OF CARBON NANOTUBES TO THE SURFACE OF A MATERIAL VIA A CARBON LAYER

(30) Priorité: 12.01.2012 FR 1250301
(43) Date de publication de la demande: 19.11.2014
(73) Titulaire: Centre National de la Recherche Scientifique (CNRS), 75794 Paris Cedex 16 (FR); CentraleSupélec, 91192 - Gif sur Yvette Cedex (FR)
(72) Inventeur: BAI, Jinbo, F-92160 Antony (FR); LIN, Youqin, F-92160 Antony (FR); DICHIARA, Anthony, 77130 Montereau-Fault-Yonne (FR)
(74) Mandataire: Novagraaf Technologies
(86) Numéro de dépôt international: PCT/FR2013/050066
(87) Numéro de publication internationale: WO 2013/104874

(56) Documents cités:
- EP-A1- 2 361 881
- EP-A2- 1 923 475
- FR-A1- 2 939 422

## Description

### Domaine technique

La présente invention se rapporte à un procédé d'amélioration de la fixation de nanotubes de carbone (abrégés NTC) sur divers renforts de type particules ou fibres et des propriétés de ces renforts hybrides comprenant de tels NTC.

Ce procédé consiste en un dépôt d'au moins une couche de carbone, en particulier d'une nanocouche de carbone, par voie chimique en phase vapeur (abrégé CVD) sur des renforts hybrides multi-échelles, tels que par exemple des particules, des fibres, lesdits renforts étant recouverts de NTC. On parle aussi d'un procédé de graphitisation. Ce procédé permet ainsi d'assurer une meilleure fixation desdits NTC sur lesdits renforts d'une part, et d'augmenter la conductivité électrique/thermique et les tenues mécaniques de ces renforts d'autre part, ainsi que d'améliorer les propriétés multifonctionnelles des matériaux composites associés.

Dans la description ci-dessous, les références entre crochets **([ ])** renvoient à la liste des références présentée à la fin du texte.

### État de la technique

Le procédé de fabrication des renforts hydrides multi-échelles, tels que par exemple des renforts hybrides de dimension micrométrique voire nanométrique par CVD, a déjà été breveté sous la référence FR0806869. Il est en particulier décrit dans le brevet FR0806869 une variante d'un procédé de synthèse de NTC à la surface d'un matériau pour des applications qui nécessitent une liaison particulièrement forte entre les NTC et le renfort. Cette variante comprend une étape supplémentaire dans laquelle soit on applique un traitement thermique permettant de créer des nanosoudures entre les NTC et le renfort soit on effectue un dépôt de polymère conducteur biocompatible sur le matériau obtenu à l'issue du procédé de synthèse des NTC.

Néanmoins, il s'avère que la fixation des NTC sur des particules et fibres par cette variante ne soit pas complètement satisfaisante et que donc la solidarisation des NTC à leur support reste une problématique nécessitant une réponse adaptée afin de ne pas faire obstacle à certaines applications envisagées. Pendant la mise en oeuvre des composites, qui consiste en une dispersion de renforts hybrides dans une matrice, et pendant l'utilisation de ces composites sous sollicitations de nature mécanique et/ou électrique et/ou chimique et/ou thermique et/ou électromagnétique, une adhésion contrôlée, souvent forte, thermiquement et chimiquement stable, est nécessaire. Cette adhésion peut améliorer la transmission du courant électrique, du flux thermique et des contraintes mécaniques entre (a) les NTC, (b) les renforts micrométriques et (c) la matrice. Les NTC peuvent, en outre, présenter un problème de sécurité lors (i) de leurs manipulations pendant les différentes étapes de production et (ii) de leurs applications, ainsi qu'au moment de leur fin de vie. En effet, de par leur taille de l'ordre du nanomètre, les NTC peuvent représenter un danger pour la santé s'ils se dispersent dans l'atmosphère sous forme libre, c'est-à-dire non attachés à un support de taille plus importante telle que, par exemple, un renfort de la taille de l'ordre du micromètre. Il existe donc un réel besoin d'améliorer la fixation et l'adhérence à long terme des NTC sur ces renforts et de pallier ainsi les inconvénients de l'art antérieur.

La Demanderesse a découvert un nouveau procédé permettant d'améliorer la fixation des NTC sur des renforts. Ce procédé consiste à déposer une fine couche de carbone qui, par ailleurs, s'avère être un excellent conducteur électrique et thermique et ayant une bonne tenue mécanique, sur des renforts hybrides composés de NTC et de particules et/ou fibres. Avantageusement, ces renforts hybrides ont une dimension micrométrique.

Ce procédé constitue un procédé de renforcement de l'adhésion de NTC à la surface d'un matériau constituant un renfort hybride, comprenant les étapes suivantes réalisées sous un courant de gaz inerte(s), éventuellement en mélange avec de l'hydrogène :
(i) chauffage dans une enceinte réactionnelle dudit renfort hybride comprenant à sa surface des NTC, à une température allant de 500°C à 1100°C,
(ii) introduction dans ladite enceinte, d'une source de carbone constituée d'acétylène et/ou de xylène, en absence de catalyseur;
(iii) exposition à la source de carbone dudit renfort hybride, chauffé pendant une durée suffisante pour obtenir une couche de carbone d'épaisseur contrôlée à la surface dudit matériau et desdits NTC le recouvrant, l'épaisseur étant contrôlée en fonction de l'application souhaitée;
(iv) récupération éventuellement après refroidissement dudit renfort hybride, obtenu à l'issue de l'étape (iii), recouvert d'une couche de carbone et comprenant des NTC gainés par une couche de carbone.

Dans le cadre de l'invention, on entend par « NTC gainés par une couche de carbone », des NTC qui sont entourés par une couche de carbone soit ayant la même structure que les NTC en eux-mêmes, C'est-à-dire que le NTC est entouré par au moins une couche de graphène concentrique; soit ayant une structure moins graphitisée pour certaines applications particulières.

Ce procédé fournit ainsi une solution technique originale permettant de renforcer et de consolider l'attachement entre les NTC et les renforts, tout en préservant, voire en améliorant leurs propriétés et offre, en outre, l'occasion d'utiliser lesdits renforts de façon sécurisée.

En effet, cette opération de renforcement contribue à la sécurité et à la protection des utilisateurs et, par conséquent, les contraintes liées à l'hygiène et la sécurité s'en voient considérablement allégées. Elle permet également d'éviter l'éventuel détachement des NTC qui peut se produire lors de la manipulation, l'utilisation et le transport desdits renforts, et l'application des matériaux préparés, par exemple de matériaux composites.

Le procédé de dépôt de carbone sur des renforts hybrides par CVD en présence d'acétylène et/ou de xylène comme sources de carbone permet un dépôt de carbone tant sur les NTC que sur les renforts, en particulier des particules ou fibres.

Il engendre un haut niveau de graphitisation de la couche de carbone déposée selon les conditions de l'invention ainsi qu'un bon attachement entre renforts micrométriques et NTC, permettant de ce fait une amélioration significative des propriétés électriques, thermiques et/ou mécaniques des produits obtenus.

Il peut permettre, en outre, un contrôle de l'épaisseur du dépôt de carbone et de la masse de carbone déposée sur les NTC et sur les renforts. Le dépôt de carbone formant des couches de graphite concentriques autour des NTC, on peut de cette manière moduler leur diamètre extérieur de façon précise et homogène.

Il existe en fait dans l'art antérieur deux voies possibles pour moduler le diamètre extérieur des NTC.

La première voie est une réaction par CVD avec des catalyseurs pré-déposés de taille contrôlée sur des substrats. Cependant cette voie entraîne un coût de production élevé, ne permet qu'une faible capacité de production, met en oeuvre un procédé en plusieurs étapes avec des techniques différentes ou onéreuses et comporte des défauts nombreux pour les diamètres importants. La seconde voie consiste en une réaction par CVD d'aérosol, les catalyseurs étant alors générés in-situ dans le gaz. Cette voie présente un coût de production faible, permet une grande capacité de production, mais le diamètre est très difficilement contrôlable. En effet, la distribution en diamètre des NTC synthétisés par CVD d'aérosol est d'autant plus multimodale que le diamètre des NTC est important.

La longueur des NTC est quand à elle déterminée au cours de leur fabrication par le temps de croissance sous influence de la température et la concentration des sources de carbone et de catalyseur.

La Demanderesse a maintenant également trouvé un procédé permettant de contrôler le diamètre extérieur des NTC de façon précise et homogène. Ce procédé d'augmentation contrôlée du diamètre des NTC comprend en outre les étapes du procédé de renforcement de l'adhésion de NTC à la surface d'un matériau constituant un renfort hybride. De plus, ce procédé a pour avantage d'utiliser le même équipement que pour la croissance desdits NTC, occasionnant ainsi une mise en oeuvre aisée, rapide et efficace. Plus particulièrement, ce procédé, peut avoir lieu par exemple directement à la suite de celui de la synthèse des renforts hybrides sans interruption et sans aucune modification du matériel utilisé. Ce procédé comprend l'application d'un CVD d'aérosol avec des catalyseurs générés in-situ.

Ce procédé comprend, préalablement aux étapes du procédé de renforcement de l'adhésion de NTC à la surface d'un matériau constituant un renfort hybride, une étape de croissance de NTC sur lesdits renforts par CVD en présence de catalyseur puis une étape de désactivation dudit catalyseur par un traitement thermique sous H₂.

Ce procédé se déroule avantageusement en 3 étapes, qui peuvent éventuellement être réalisées en continu, et permet de conserver les avantages de coût faible et de grande capacité de production tout en évitant les inconvénients de l'art antérieur.

La première étape peut donc consister à faire croitre selon une croissance dite « normale » ou « standard » par CVD d'aérosol des NTC de longueur désirée et de petits diamètres entre 3 et 20 nm afin d'obtenir une distribution en diamètre des NTC uniforme et monodisperse.

La seconde étape peut consister en une désactivation des catalyseurs présents à la suite de la croissance « normale » évoquée précédemment, par un traitement thermique sous H₂, de sorte que les NTC ne puissent continuer à croître en longueur lors de l'étape suivante.

La troisième étape, reprenant le procédé selon l'invention, consiste à mettre en oeuvre un procédé CVD mais sans l'apport de catalyseur, le carbone pyrolytique formé au cours de ce procédé par les sources de carbone apportées étant alors déposé autour de ces NTC d'une manière concentrique, à la façon d'un fourreau, pour atteindre le diamètre extérieur désiré en gardant inchangé le diamètre intérieur et la longueur des NTC. Les différentes méthodes de caractérisations (Raman, HRTEM, MEB, diffraction) ont montré une structure avec une bonne graphitisation du carbone déposé, semblable à celle des NTC d'origine.

Ainsi, le procédé de renforcement de l'adhésion de NTC à la surface d'un matériau constituant un renfort hybride, tel que décrit ci-dessous, peut s'avérer être avantageusement un procédé permettant l'augmentation contrôlée du diamètre de NTC. En effet, il est possible en fonction des conditions opératoires mises en oeuvre de contrôler le diamètre final des NTC et ainsi de fabriquer des NTC uniformes avec un diamètre bien précis.

Le procédé d'augmentation contrôlée du diamètre de NTC, qui peut permettre une augmentation du diamètre pouvant atteindre jusqu'à 200 nm supplémentaires par pas de 0,34 nm, comprend , en outre, les étapes du procédé de renforcement de l'adhésion de NTC à la surface d'un matériau constituant un renfort hybride. Ce procédé peut comprendre, préalablement aux étapes du procédé de renforcement de l'adhésion de NTC à la surface d'un matériau constituant un renfort hybride, une étape de croissance de NTC sur lesdits renforts par CVD en présence de catalyseur, tel qu'un métallocène comme le ferrocène (Fe(C5H5)2), puis éventuellement une étape de désactivation dudit catalyseur par un traitement sous H₂.

Enfin, le procédé selon l'invention utilisé soit pour renforcer l'adhésion ou la fixation de NTC à la surface d'un matériau, constituant ainsi un renfort hybride, et/ou soit pour moduler ou contrôler le diamètre des NTC, favorise la réduction de produits dangereux tels que le benzène et le toluène, produits de dégradation du xylène lorsque les deux sources de carbone, acétylène et xylène, sont utilisées simultanément.

Dans le cadre de la présente invention, on entend par « matériau composite », un matériau comprenant au moins deux composants : L'un est « la matrice » qui assure la cohésion du composite, l'autre est « le renfort » qui assure au composite des qualités physiques et mécaniques intéressantes.

Dans le cadre de la présente invention, on entend par « renfort », un matériau pouvant être utilisé pour assurer, par exemple, aux matériaux composites des propriétés physiques et mécaniques, comme par exemple (i) la résistance à la traction, à la torsion, à la flexion et à la compression, (ii) rigidité et durée de vie, (iii) allégement du poids spécifique, (iv) résistance à la corrosion, (v) conductivité électrique et thermique et (vi) blindage des ondes électromagnétiques.

Dans le cadre de la présente invention, on entend par « renfort hybride », un renfort, tel que défini précédemment, pouvant se présenter sous la forme d'un renfort conventionnel, à la surface desquels des NTC ont été synthétisés, choisi par exemple parmi le groupe comprenant :
- des fibres de carbone, de verre, d'alumine, de carbure de silicium (SiC), de roche ;
- des matériaux céramiques choisis dans le groupe comprenant des particules et/ou fibres de nitrure de silicium (Si₃N₄), carbure de bore (B₄C), carbure de silicium (SiC), carbure de titane (TiC), cordiérite (Al₃Mg₂AlSi₅O₁₈), mullite (Al₆Si₂O₁₃), nitrure d'aluminium (AIN), nitrure de bore (NB), alumine (Al₂O₃), borure d'aluminium (AlB₂), oxyde de magnésium (MgO), oxyde de zinc (ZnO), oxyde magnétique de fer (Fe₃O₄) zircone (Zr₂O), silice (Si₂O), fumées de silice, CaO, La₂CuO₄, La₂NiO₄, La₂SrCuO₄, Nd₂CuO₄, TiO₂, Y₂O₃, silicates d'aluminium (argiles).

Dans le cadre de la présente invention, on entend par « nanotube », une structure tubulaire à base de carbone, qui possède un diamètre compris entre 0,5 et 100 nm. Ces composés appartiennent à la famille dite des « matériaux nanostructurés » qui présentent au moins une dimension caractéristique de l'ordre du nanomètre.

Le procédé, objet de la présente invention, est le même qu'il s'agisse de recouvrir des renforts hybrides composés (i) de fibres et de NTC ou et (ii) de particules et de NTC.

Le procédé de l'invention présente l'avantage de convenir à tous types de matériau, quelle que soit sa structure : fibres courtes, longues ou continues, particules. Dans le sens de l'invention, une fibre est dite « longue ou continue » lorsque sa longueur est égale ou supérieure à 10 cm et une fibre est dite « courte » lorsque sa longueur est inférieure à 10 cm.

### Description technique détaillée de l'invention

La présente invention a ainsi pour but de fournir un procédé de renforcement de l'adhésion de NTC à la surface d'un matériau constituant un renfort hybride, comprenant les étapes suivantes réalisées sous un courant de gaz inerte(s), éventuellement en mélange avec de l'hydrogène :
(i) chauffage dans une enceinte réactionnelle dudit renfort hybride comprenant à sa surface des NTC, à une température allant de 500°C à 1100°C, avantageusement entre 700°C à 900°C, encore plus avantageusement entre 750°C et 850°C;
(ii) introduction dans ladite enceinte, d'une source de carbone constituée d'acétylène et/ou de xylène, en absence de catalyseur;
(iii) exposition à la source de carbone dudit renfort hybride, chauffé pendant une durée suffisante pour obtenir une couche de carbone d'épaisseur contrôlée à la surface dudit matériau et desdits NTC le recouvrant, l'épaisseur étant contrôlée en fonction de l'application souhaitée, avantageusement l'épaisseur de la couche de carbone formée étant comprise entre 0,002 et 5 µm, encore plus avantageusement entre 2 et 250 nm;
(iv) récupération éventuellement après refroidissement dudit renfort hybride, obtenu à l'issue de l'étape (iii), recouvert d'une couche de carbone et comprenant des NTC gainés par une couche de carbone.

Selon un mode de réalisation, ledit procédé de renforcement de l'adhésion de NTC à la surface d'un matériau ou renfort, peut être en continu. Par procédé en continu, on entend un procédé dans lequel l'introduction des matériaux ou renforts hybrides, à la surface desquels la couche de carbone est déposée, ne nécessite pas l'arrêt de l'équipement ni l'interruption de la production.

Selon l'épaisseur de la couche de carbone souhaitée, le renfort hybride peut être exposé à la source de carbone pendant une durée de 1 à 60 minutes dans l'étape (iii). Cette durée peut être de 1 à 30 minutes, ou encore de 5 à 15 minutes.

L'homme du métier saura adapter cette durée selon d'une part l'épaisseur de la couche de carbone recherchée, l'application des renforts hybrides visée et le risque de dégradation du matériau composant lesdits renforts lors du procédé selon l'invention.

En outre, dans l'étape (iv), le renfort hybride recouvert d'une couche de carbone obtenu à l'issue de l'étape (iii) peut être récupéré éventuellement après une étape de refroidissement à une température comprise entre 15 et 150°C. A l'issue de l'étape (iv), le renfort hybride recouvert d'un dépôt de carbone peut être utilisé tel quel dans les différentes applications envisagées.

Le principe du procédé de dépôt de carbone sur des renforts hybrides repose sur un mécanisme consistant à réaliser le dépôt de carbone sur des renforts hybrides composés de préférence de particules et/ou fibres avantageusement par la méthode de CVD dans un réacteur placé dans un four chauffé entre 500 et 1100 °C, alimenté d'acétylène, en continu, et/ou de xylène, en tant que source(s) de carbone.

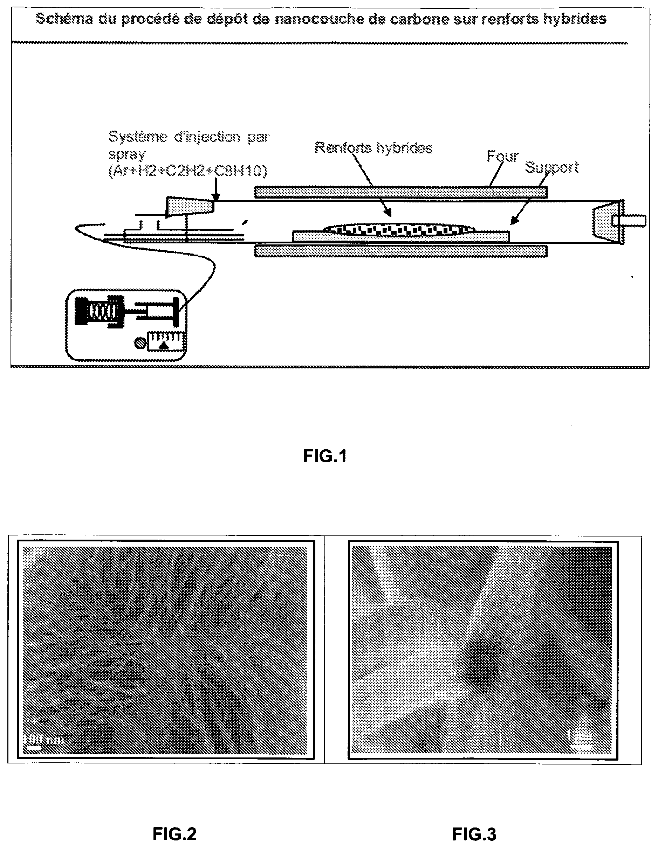

L'enceinte réactionnelle peut être tout dispositif muni d'au moins un four et permettant l'injection simultanée et contrôlée de source de carbone gazeuse et/ou de source de carbone liquide. Le dispositif est avantageusement muni d'au moins un système de circulation des gaz et d'au moins un débitmètre gaz et/ou liquide en fonction de la source de carbone utilisée permettant de mesurer et contrôler précisément les débits des gaz et/ou des liquides. Un exemple de dispositif est représenté en figure 1.

Le flux liquide de xylène peut être contrôlé par une seringue mécanique et/ou un débitmètre massique liquide commercial. Quant au débit gazeux d'acétylène, de gaz inerte et éventuellement mélangé d'hydrogène, il peuvent être contrôlés par lesdit débitmètres massiques numériques commerciaux.

Le système utilisé pour l'introduction du liquide peut être tout système permettant son injection par exemple un atomiseur, un vaporisateur, un nébulisation, un aérobrumisateur.

Selon un mode de réalisation du procédé particulièrement avantageux, dans l'étape (ii), le liquide est introduit dans l'enceinte réactionnelle sous forme de micro gouttelettes via un spray à une vitesse pouvant aller de 0 à 30 ml/heure.

Selon un mode de réalisation du procédé, dans l'étape (ii), l'acétylène est introduit dans l'enceinte réactionnelle avec une vitesse linéaire comprise entre 5,0 x 10⁻⁶ et 1,0 x 10⁻¹ m/s et/ou le xylène est introduit dans l'enceinte réactionnelle à un débit variant entre 0,1 et 0,7 ml/min.

On entend par « vitesse linéaire », la distance parcourue par l'acétylène en 1 seconde. La vitesse linéaire se détermine en fonction du débit de l'acétylène et du volume de l'enceinte réactionnelle. Par exemple, pour un réacteur de diamètre intérieur de 45 mm, un débit de gaz de 1 L/min correspond à une vitesse linéaire de 0,0095 m/s. Ceci est vrai pour les gaz utilisés dans le cadre de la présente invention.

Les étapes (i) à (iv) peuvent être réalisées sous un courant de gaz inerte(s) éventuellement en mélange avec de l'hydrogène avec un rapport hydrogène/gaz inerte(s) allant de 0/100 à 50/50, par exemple de 10/100 à 40/60. Le gaz inerte peut être choisi dans le groupe comprenant l'hélium, le néon, l'argon, l'azote et le krypton.

Ainsi dans l'étape (ii), l'acétylène peut être introduit dans l'enceinte réactionnelle sous forme de gaz en une quantité supérieure à 0 et allant jusqu'à 20% en volume du gaz total présent dans ladite enceinte. Il peut encore être introduit, par exemple, en une quantité allant de 0,1 à 10% en volume du gaz total.

La mise en oeuvre des dispositions qui précédent permet de contrôler le dépôt et donc l'épaisseur de la couche de carbone recouvrant à la fois renforts et NTC.

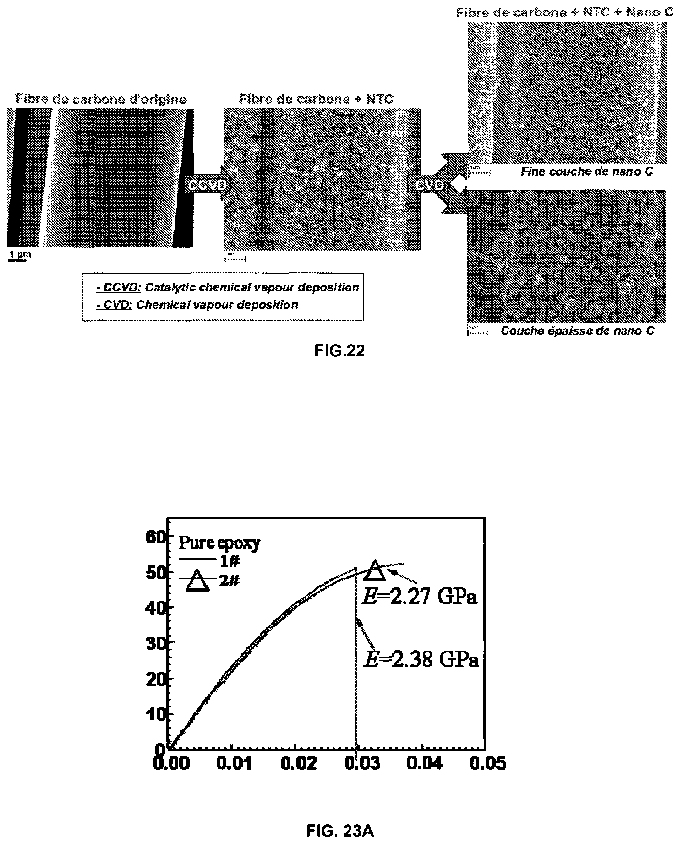

Selon un mode de réalisation du procédé, dont des photographies de NTC sont visibles en figure 22, le renfort dans ledit renfort hybride se présente sous forme de fibres, courtes ou longues, de diamètre de 1 à 100 µm, en particulier de fibres de diamètre de 4 à 50 µm, ou de particules de diamètre de 0,1 à 100 µm.

Le matériau constituant le renfort à traiter est choisi parmi ceux capables de supporter la température du procédé selon les conditions de l'invention.

Ce matériau peut être choisi dans le groupe comprenant :
- des fibres de carbone, de verre, d'alumine, de carbure de silicium (SiC), de roche ;
- des matériaux céramiques choisis dans le groupe comprenant des particules et/ou fibres de nitrure de silicium (Si₃N₄), carbure de bore (B₄C), carbure de silicium (SiC), carbure de titane (TiC), cordiérite (Al₃Mg₂AlSi₅O₁₈), mullite (Al₆Si₂O₁₃), nitrure d'aluminium (AIN), nitrure de bore (NB), alumine (Al₂O₃), borure d'aluminium (AlB₂), oxyde de magnésium (MgO), oxyde de zinc (ZnO), oxyde magnétique de fer (Fe₃O₄) zircone (Zr₂O), silice (Si₂O), fumées de silice, CaO, La₂CuO₄, La₂NiO₄, La₂SrCuO₄, Nd₂CuO₄, TiO₂, Y₂O₃, silicates d'aluminium (argiles).

La performance de ce procédé novateur dépend du contrôle de la morphologie et de la structure de la couche de carbone déposée. Des précurseurs chimiques différents, tels que l'acétylène et le xylène, sont mis en oeuvre avec des paramètres physiques divers, tels que la température et le temps, de manière à optimiser le processus de dépôt de carbone sur les renforts hybrides en fonction des applications souhaitées.

Il est possible d'appliquer un haut degré de contrôle de l'épaisseur de dépôt de carbone et de sa masse par manipulation des paramètres de déposition. Le haut degré de contrôle de l'épaisseur de la couche de dépôt de carbone, de la masse de carbone déposé sur les renforts hybrides ainsi que le taux de graphitisation peuvent être ajustés en fonction du temps de dépôt et de la température du procédé. Le temps de dépôt peut linéairement augmenter la quantité de dépôt, c'est à dire l'épaisseur de la couche de carbone, alors que la température de dépôt influence non-linéairement la quantité de carbone déposé, ainsi que sa structure.

Le procédé selon l'invention permet le dépôt de carbone sur la surface des renforts hybrides, y compris sur la surface des NTC. Le temps de déposition influence peu la qualité de la graphitisation, c'est-à-dire la qualité de la structure du carbone déposé, tandis qu'une haute température de dépôt est favorable à une meilleure graphitisation, c'est-à-dire est favorable à la formation d'une structure carbonée graphitique présentant peu de défauts.

Le dépôt de carbone sur les renforts hybrides améliore l'attachement entre les NTC et les renforts micrométriques, tels que par exemple les particules et les fibres micrométriques, et les NTC. Il a été prouvé par des tests d'arrachement par ultrasons que les renforts hybrides après le dépôt de carbone peuvent davantage résister aux chocs, contraintes et/ou agitations et donc au détachement comparés aux renforts hybrides d'origine. La dispersion des NTC dans l'air est réduite ainsi efficacement.

En outre, les propriétés électriques des renforts hybrides s'en voient améliorées. Le dépôt de carbone sur des renforts micrométriques isolants de renforts hybrides permet une meilleure conduction électrique/thermique entre les NTC, tandis que le dépôt de carbone sur les NTC peut, selon son taux de graphitisation, les rendre électriquement moins conducteur que les NTC d'origine. Dans les renforts hybrides avec une basse densité en NTC, la conductivité électrique des renforts hybrides peut être augmentée en raison du dépôt de carbone sur la surface des renforts micrométriques.

Il est possible de réaliser le procédé avec l'acétylène comme seule source de carbone selon une première variante ou avec un mélange acétylène/hydrocarbure liquide tels que le xylène comme sources de carbone selon une seconde variante.

Dans le cas où l'acétylène seul est utilisé comme source de carbone unique, la couche de carbone déposée est plus fine, le procédé selon l'invention est stable mais le temps de dépôt est plus long comparé au procédé utilisant l'acétylène et le xylène simultanément.

Le procédé selon l'invention mettant en jeu un mélange d'acétylène et de xylène comme source de carbone est donc particulièrement avantageux et permet un traitement satisfaisant des renforts hybrides, tout en favorisant la réduction de produits dangereux tels que le benzène et le toluène, issus de la dégradation du xylène.

Ce nouveau procédé revêt un intérêt industriel :
Il permet un dépôt d'une couche de carbone homogène sur la surface de renforts hybrides composés, par exemple de particules micrométriques, de nanotubes ou nanofils carboniques ou d'autre nature. Pratiquement tous types de renforts peuvent être envisagés.
Il permet d'obtenir le dépôt d'une couche de carbone avec une structure variable selon les conditions de température appliquées (carbone amorphe ou graphite).
Il permet aussi un haut degré de contrôle de l'épaisseur ou de la quantité de carbone déposé sur les renforts hybrides et, par conséquent, un haut degré de contrôle sur le diamètre des NTC dans le cas d'un dépôt de graphite concentrique autour des NTC.
Il permet enfin de moduler la conductivité électrique/thermique et les propriétés mécaniques des renforts hybrides selon la morphologie des renforts et les applications pratiques envisagées.

L'invention a également pour objet un renfort hybride, c'est-à-dire un renfort ou matériau recouvert de NTC, susceptible d'être obtenu par un procédé tel que défini précédemment, sachant que ledit renfort et lesdits NTC sont recouverts d'une couche de carbone. On obtient donc un système, renfort et NTC, recouvert d'une couche de carbone homogène.

Selon un mode de réalisation, ledit renfort hybride a une prise de masse comprise entre 0 et 150% par rapport à la masse du matériau de départ.

Le renfort hybride selon l'invention est recouvert d'une couche de carbone et comprend des NTC gainés par ladite couche de carbone.

Le renfort hybride selon l'invention se présente sous la forme d'un renfort recouvert de NTC, ledit renfort et les dits NTC étant recouverts d'une couche de carbone d'épaisseur contrôlée, l'épaisseur étant contrôlée en fonction de l'application souhaitée, avantageusement l'épaisseur de la couche de carbone formée étant comprise entre 0,002 et 5 µm, encore plus avantageusement entre 2 et 250 nm.

Le matériau constituant le renfort est choisi parmi ceux capables de supporter une température d'au moins 500°C, voire une température pouvant atteindre 1100°C. Il peut être choisi dans le groupe comprenant :
- des fibres de carbone, de verre, d'alumine, de carbure de silicium (SiC), de roche ;
- des matériaux céramiques choisis dans le groupe comprenant des particules et/ou fibres de nitrure de silicium (Si₃N₄), carbure de bore (B₄C), carbure de silicium (SiC), carbure de titane (TiC), cordiérite (Al₃Mg₂AlSi₅O₁₈), mullite (Al₆Si₂O₁₃), nitrure d'aluminium (AIN), nitrure de bore (NB), alumine (Al₂O₃), borure d'aluminium (AlB₂), oxyde de magnésium (MgO), oxyde de zinc (ZnO), oxyde magnétique de fer (Fe₃O₄) zircone (Zr₂O), silice (Si₂O), fumées de silice, CaO, La₂CuO₄, La₂NiO₄, La₂SrCuO₄, Nd₂CuO₄, TiO₂, Y₂O₃, silicates d'aluminium (argiles).

Le renfort dans ledit renfort hybride peut se présenter sous forme de fibres, courtes ou longues telles que définies ci-dessus, de diamètre de 1 à 100 µm, en particulier de fibres de diamètre de 4 à 50 µm, ou de particules de diamètre de 0,1 à 100 µm.

Enfin, l'invention concerne aussi l'utilisation dudit renfort hybride pour la préparation de matériaux composites structuraux et fonctionnels ou pour la préparation de peintures ou vernis ou encore des fils ou des bandes.

Ces utilisations sont particulièrement favorisées par les avantages conférés par le produit obtenu à l'issue du procédé et qui sont en lien direct avec les conditions réactionnelles. Les avantages du dépôt en phase vapeur, sans catalyseur chimique, combinant deux espèces de source de carbone: l'acétylène, gazeux, et le xylène, liquide, peuvent être résumés tel que suit :
> Le dépôt d'une couche mince de carbone sur les renforts hybrides composés de particules micrométriques et de NTC permet de mieux fixer lesdits NTC sur la surface desdites particules et/ou fibres micrométriques.
> La couche de carbone déposée au cours du procédé selon l'invention est électriquement et thermiquement conductrice, et donc ne détériore pas la conductivité électrique/thermique des NTC.
> Le dépôt par CVD sous gaz inerte à température élevée a l'avantage de permettre un plus haut niveau de graphitisation et une structure du dépôt de carbone plus homogène et de meilleure qualité comparée avec les structures obtenues par d'autres techniques de déposition carbonique à basse température, comme le laser d'impulsion [1], le plasma [2], l'électrodéposition [3], etc.
> L'utilisation de molécules conjuguées comme source de carbone (l'acétylène, le xylène) peut aboutir à une concentration plus élevée de liaisons sp2 dans le dépôt de carbone que d'autres sources de carbone non-conjuguées à basse température. Il a ainsi été montré que le dépôt de carbone dérivé de l'acétylène a un ordre cristallin plus haut correspondant à un taux de graphitisation plus élevé et moindre de joints de grains que les alkyls.[4]. Cela aide à augmenter la conductivité de la couche de dépôt de carbone.
> L'utilisation simultanée d'acétylène avec un autre hydrocarbure tel le xylène peut permettre un contrôle du taux de dépôt de carbone dans une large gamme de paramètres sur les renforts hybrides en ajustant la température de déposition. Il est ainsi possible de déposer le carbone à une température inférieure si nécessaire avec un mélange d'acétylène/xylène (550 °C avec le xylène au lieu de 750 °C sans xylène). Dans ce cas le taux de graphitisation du dépôt de carbone sera moins élevé mais le dépôt de carbone pourra alors être réalisé en surface de matériaux thermiquement moins résistants. L'utilisation de source carbonique gazeuse permet, en outre, un dépôt plus homogène de carbone et souvent moins rapide sur les renforts hybrides que l'utilisation de seule source de carbone liquide.
> Finalement, la concentration en benzène et toluène lors du procédé de déposition (un des produits pyrolytique du xylène) peut être baissée en utilisant simultanément le xylène et l'acétylène comme sources de carbone du procédé selon l'invention.

Le carbone en tant que matériau de dépôt permet, en outre, d'assurer et d'augmenter (i) la conductivité électrique/thermique et les propriétés mécaniques de ces renforts ainsi que des composites associés comme le montrent les tests de conductivité électrique et de propriétés mécaniques. De même, dans des applications à hautes températures et/ou en milieu corrosif, le choix du carbone s'avère être particulièrement intéressant pour sa stabilité thermique et chimique.

De plus, l'objet de la présente technique a pour avantage supplémentaire de fournir un procédé de renforcement de la fixation des NTC sur des renforts hybrides utilisant le même équipement que pour la croissance desdits NTC sur lesdits renforts, occasionnant ainsi une mise en oeuvre aisée, rapide et efficace. Plus particulièrement, ce procédé, qui peut avoir lieu directement à la suite de celui de la synthèse des renforts hybrides sans interruption et sans aucune modification du matériel utilisé, permet de maîtriser à la fois l'épaisseur de la couche de carbone déposée sur les renforts hybrides et en particulier le diamètre des NTC, améliorant ainsi l'adhérence des NTC sur les renforts micrométriques attestée par des tests de résistances aux ultrasons

D'autres avantages pourront encore apparaître à l'homme du métier à la lecture des exemples ci-dessous, illustrés par les figures annexées, donnés à titre illustratif.

### Brève description des figures

La figure 1 représente le schéma d'un montage utilisé pour le procédé de renforcement de l'adhésion de NTC à la surface d'un matériau par CVD.

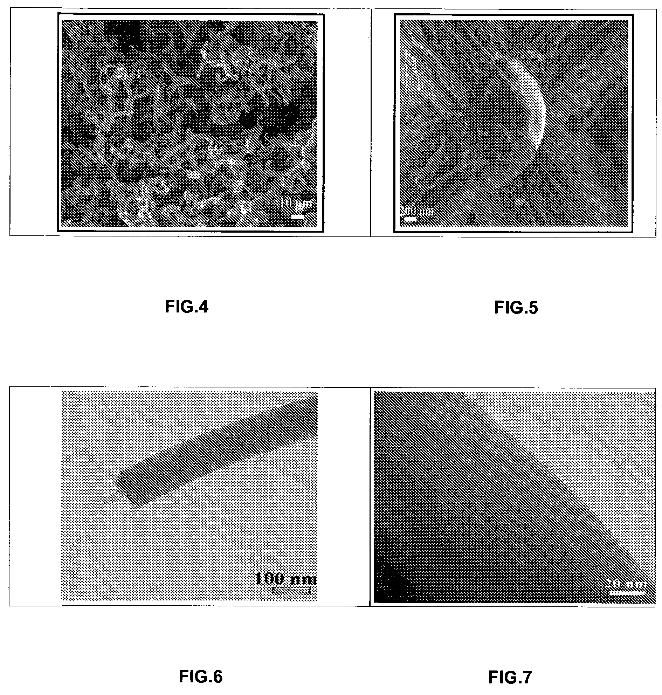

Les figures 2, 3, 4, 5, 6 et 7 sont des images obtenues par microscope électronique à balayage (MEB) d'un renfort hybride composé de NTC et d'une microparticule, accentuant la différence morphologique avec une couche de dépôt de carbone d'épaisseur variable sur la surface d'une microparticule et de NTC pour les figures 4, 5, 6 et 7 ou sans couche de dépôt de carbone sur la surface d'une microparticule et de NTC pour les figures 2 et 3.
Les figures 4 et 5 montrent des renforts hybrides selon l'invention avec un dépôt de carbone sur la surface desdits renforts obtenus par la méthode de CVD.
Les figures 6 et 7 montrent les détails du dépôt sur la surface d'une microparticule et d'un NTC. La figure 6 montre un agrandissement d'un NTC apparaissant en gris clair gainé par une couche de carbone plus sombre et la figure 7 montre une couche de dépôt homogène apparaissant en gris foncé sur la surface de la microparticule qui apparait en noir.

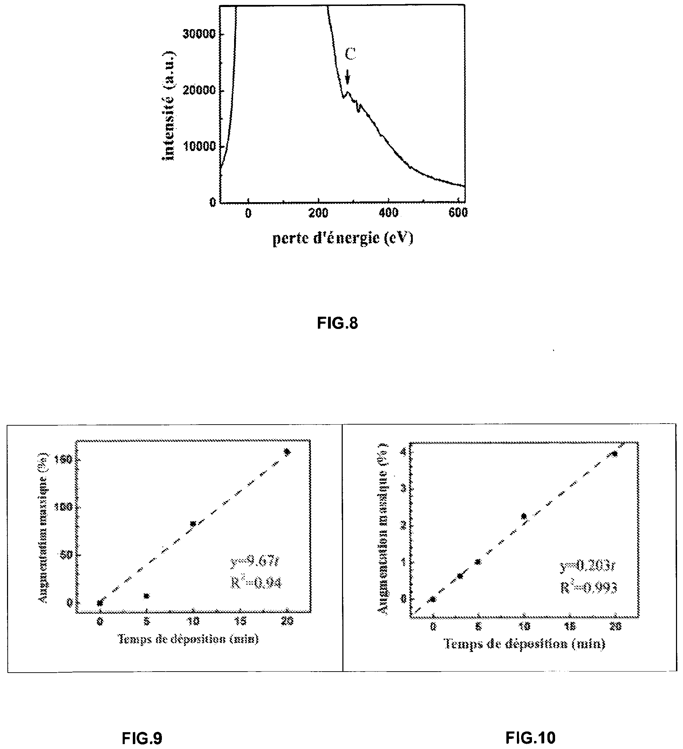

La figure 8 montre le résultat de l'analyse spectroscopique de la perte d'énergie électronique à la surface d'une particule après le dépôt de carbone, confirmant la présence d'une couche de carbone d'épaisseur nanométrique.
La figure 9 représente l'évolution de la masse de carbone déposé sur un renfort hybride en fonction du temps de déposition de carbone.
La figure 10 représente, l'évolution de la masse de carbone déposé sur un nanotube seul en fonction de la durée de déposition de carbone.
La figure 11 montre l'augmentation linéaire du diamètre de NTC en fonction du temps de dépôt de carbone.

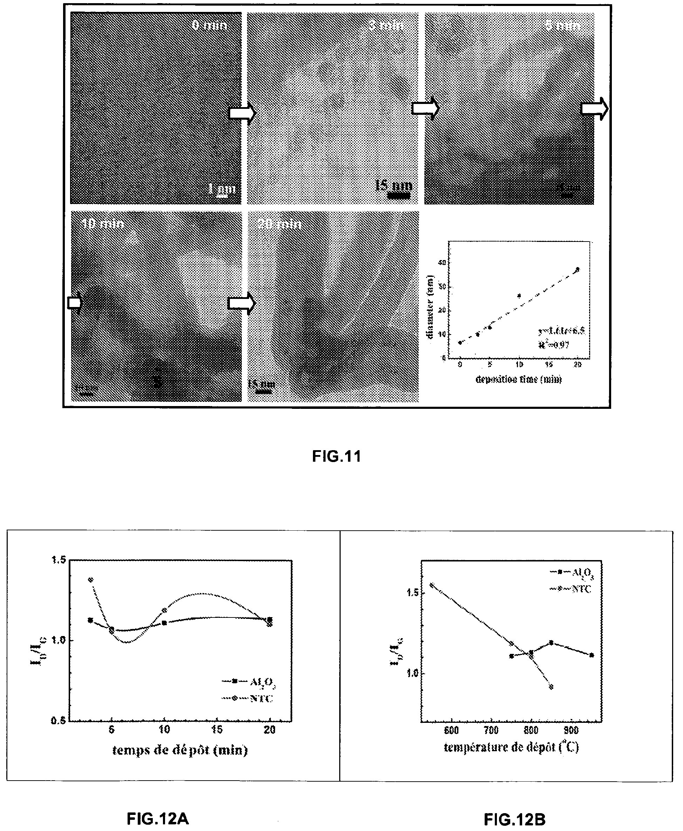

Les figures 12A et 12B montrent l'influence des paramètres de synthèse. La figure 12A montre l'influence de la durée de dépôt et la figure 12B montre l'influence de la température de dépôt sur le ratio de l'intensité de la bande D et de la bande G (ID/IG) obtenu par spectroscopie Raman, qui est conventionnellement utilisée pour évaluer quantitativement la qualité structurelle des NTC (aussi appelé taux de graphitisation). Le temps de dépôt, a peu d'influence sur le rapport ID/IG du dépôt de carbone sur la surface des particules micrométriques. Mais une haute température de déposition de carbone sur les NTC est favorable à un ratio ID/IG plus bas que celui précédent, ce qui suggère la présence de peu de défauts structurels et donc d'une pureté élevée de la couche de carbone déposée sur les NTC [8]. Le procédé de dépôt d'une nanocouche de carbone n'augmente donc pas la quantité de défauts des NTC. Ce procédé peut donc également être utilisé afin d'augmenter à postériori le diamètre externe des NTC de façon homogène et précise sans modifier la nature de ces derniers.

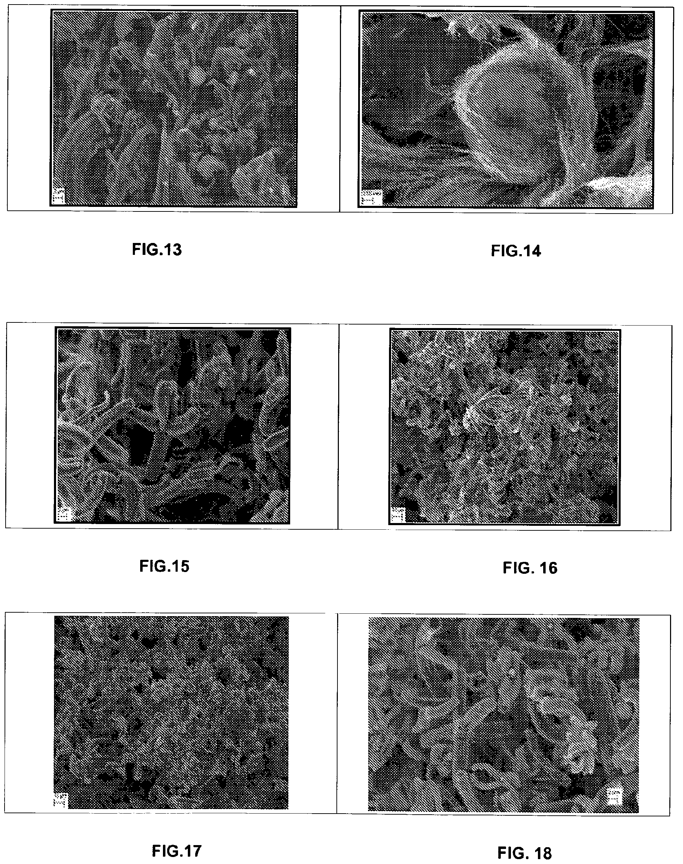

Les figures 13 - 18 montrent l'effet de la fixation des NTC par dépôt de carbone sur la surface de renforts hybrides. Les figures 13 et 14 constituent des images obtenues par MEB montrant le détachement des NTC de renforts hybrides, sans le dépôt de carbone, après respectivement 1 minute et 5 minutes d'ultrasons à basse puissance. Les figures 15 et 16 constituent des images obtenues par MEB montrant, sous les mêmes conditions opératoires, c'est-à-dire après respectivement 1 minute et 5 minutes d'ultrasons à basse puissance, que les NTC recouverts d'une couche de carbone restent soudés aux renforts recouverts de carbone,, dont ils dépendent. Les figures 17 et 18 constituent des images obtenues par MEB montrant que, même après 30 minutes d'exposition à des ultrasons à puissance maximale, la morphologie des renforts hybrides recouvert d'une couche de carbone est conservée, démontrant ainsi que le dépôt d'une couche de carbone sur les renforts hybrides aide à mieux fixer des NTC sur la surface des particules micrométriques.

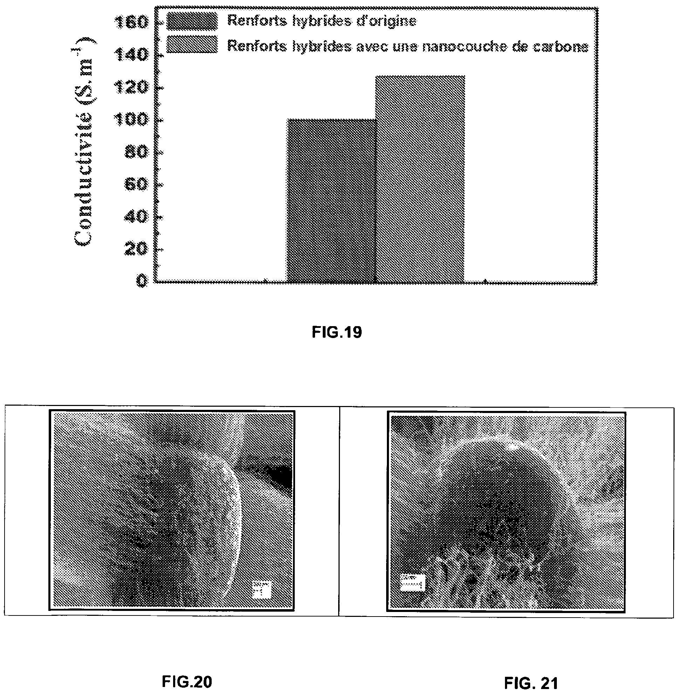

La figure 19 montre la comparaison de la conductivité électrique de renforts hybrides avant et après dépôt de carbone, mettant en évidence l'influence positive du dépôt de carbone sur les propriétés électriques des renforts hybrides.
Les figures 20 et 21 sont des images obtenues par MEB montrant des renforts hybrides recouverts d'une couche de carbone. Sur la figure 20, la couche de dépôt de carbone est réalisée avec un procédé utilisant l'acétylène. On observe une couche de dépôt de carbone mince. Sur la figure 21, la couche de dépôt de carbone sur le renfort hybride est obtenue avec un procédé utilisant un mélange de xylène et d'acétylène. L'épaisseur de la couche de dépôt de carbone est satisfaisante pour fixer des NTC sur la surface des renforts.
La figure 22 regroupe des images obtenues par MEB montrant (i) une fibre de carbone nue (image de gauche) puis montrant (ii) la même fibre de carbone recouverte de NTC dite également fibre hybride, après croissance desdits NTC par CVD catalytique (image du milieu), et enfin montrant (iii) ladite fibre hybride recouverte d'une fine couche de carbone (image de droite en haut) ou d'une épaisse couche de carbone (image de droite en bas) selon le procédé de l'invention.
Les figures 23A, 23B et 23C représentent les courbes de traction (i) de résine pour la figure 23a, (ii) de composites comportant 0,5% en masse de renforts hybrides (particules hybrides d'Al₂O₃) non conformes à l'invention pour la figure 23b et de composites comportant 0,5% en masse de renforts hybrides (particules hybrides d'Al₂O₃) revêtues d'une nanocouche de carbone conformes à l'invention pour la figure 23c.

### EXEMPLES

### Exemple 1

Le dépôt d'une nanocouche de carbone est réalisé sur des fibres de carbone dites « longues ou continue » d'une longueur de 20 cm greffées de nanotubes de carbone dont la synthèse est décrite dans le brevet FR0806869. Le dépôt de carbone est obtenu dans le même réacteur CVD que celui décrit plus haut et représenté en figure 1 et peut éventuellement être effectué en dynamique pour un traitement en continu des différents matériaux.

L'épaisseur, la morphologie et les propriétés structurales de la couche de carbone déposée sont contrôlées en ajustant finement les paramètres du procédé selon l'invention (température, temps, débit de gaz...) selon les conditions suivantes :

| **Paramètres** | **Couche fine de nano C** | **Couche épaisse de nano C** |
|---|---|---|
| **Température (°C)** | 850 | 850 |
| **Source(s) de carbone** | C₈H₁₀ 10 mUh | C₂H₂ 0,05 L/min + C₈H₁₀ 10 mL/h |
| **Temps (min)** | 15 min | 15 min |
| **Gaz vecteurs (L/min)** | Ar 0,8 + H₂ 0,2 | Ar 0,8 + H₂ 0,2 |

Les fibres de carbones sont photographiées par microscopie électronique à différentes étapes du processus de fabrication des renforts hybrides selon l'invention et sont visibles en figure 22.

### Exemple 2

Des particules d'alumine de diamètre compris entre 1 et 5 µm recouvertes de NTC , dite renfort hybride d'origine, sont mises dans un four tel que représenté sur la figure 1. Le procédé selon l'invention est alors mis en oeuvre avec les conditions suivantes :
Température du four: 850 °C,
Temps de dépôt : 20 min,
Gaz inerte: Ar: 0,8 L/min; H₂: 0,2 L/min;
Source de carbones:
   C₂H₂, injecté à une vitesse de 0,05 L/min
   Xylène, injecté à une vitesse de 10 ml/h

A l'issue de ce procédé, une nanocouche de carbone a été déposée sur la structure hybride particule d'alumine recouverte de NTC afin de fixer d'avantage les NTC sur les particules d'alumine.

Des tests d'arrachement effectués par ultrasons attestent d'une amélioration significative de l'adhésion des NTC sur les particules d'alumine comme le montre les figures 13 à 18.

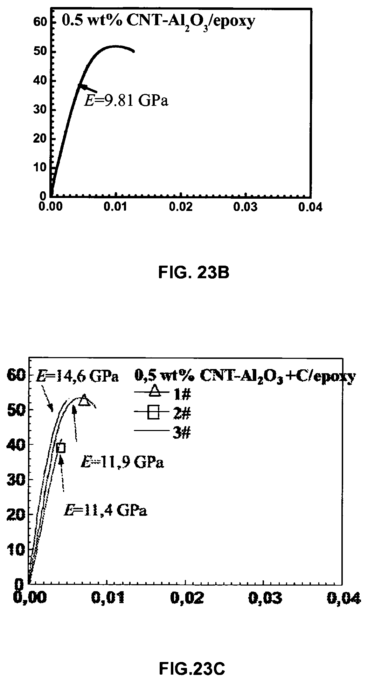

En comparant la courbe de traction (i) d'une résine époxy (Résoltech® 1080S et 1084) de la figure 23a, (ii) la courbe de traction d'un composite dont la matrice est cette même résine époxy mélangée à 0,5% en masse de renforts hybrides (NTC sur les microparticules d'Al₂O₃) d'origine de la figure 23b et (iii) la courbe de traction d'un composite dont la matrice est cette même résine époxy mélangée à 0,5% en masse de renforts hybrides (NTC sur les microparticules d'Al₂O₃) revêtues d'une nanocouche de carbone, conformes à l'invention, de la figure 23c, on constate que le module a été multiplié par 4 ou 6 respectivement.

### RÉFÉRENCES

1. Honglertkongsakul, K., P.W. May, and B. Paosawatyanyong, Electrical and optical properties of diamond-like carbon films deposited by pulsed laser ablation. Diamond and Related Materials, 2010. 19(7-9): p. 999-1002.
2. Zeb, S., et al., Deposition of Diamond-like Carbon Films using Graphite Sputtering in Neon Dense Plasma. Plasma Chemistry and Plasma Processing, 2007. 27(2): p. 127-139.
3. Manhabosco, T.M. and I.L. Muller, Electrodeposition of diamond-like carbon (DLC) films on Ti. Applied Surface Science, 2009. 255(7): p. 4082-4086.
4. Taylor, C.A. and W.K.S. Chiu, Characterization of CVD carbon films for hermetic optical fiber coatings. Surface & Coatings Technology, 2003. 168(1): p. 1-11.
5. Mahajan, S.S., et al., Monitoring structural defects and crystallinity of carbon nanotubes in thin films. Pramana-Journal of Physics, 2010. 74(3): p. 447-455.

## Revendications

1. Procédé de renforcement de l'adhésion de nanotubes de carbone à la surface d'un matériau constituant un renfort hybride, comprenant les étapes suivantes réalisées sous un courant de gaz inerte(s) éventuellement en mélange avec de l'hydrogène :
(i) chauffage dans une enceinte réactionnelle dudit renfort hybride comprenant à sa surface des NTC, à une température allant de 500°C à 1100°C ;
(ii) introduction dans ladite enceinte, d'une source de carbone constituée d'acétylène et/ou de xylène, en absence de catalyseur;
(iii) exposition à la source de carbone dudit renfort hybride, chauffé pendant une durée suffisante pour obtenir une couche de carbone d'épaisseur contrôlée à la surface dudit matériau et desdits NTC le recouvrant;
(iv) récupération éventuellement après refroidissement dudit renfort obtenu à l'issue de l'étape (iii), recouvert d'une couche de carbone et comprenant des NTC gainés par une couche de carbone.

2. Procédé selon la revendication 1, dans lequel le renfort dans ledit renfort hybride se présente sous forme de fibres, courtes ou longues, de diamètre de 1 à 100 µm, en particulier de fibres de diamètre de 4 à 50 µm, ou de particules de diamètre de 0,1 à 100 µm.

3. Procédé selon l'une quelconque des revendications 1 ou 2, dans lequel le matériau utilisé comme renfort est choisi dans le groupe comprenant :
- des fibres de carbone, de verre, d'alumine, de carbure de silicium (SiC), de roche ;
- des matériaux céramiques choisis dans le groupe comprenant des particules et/ou fibres de nitrure de silicium (Si₃N₄), carbure de bore (B₄C), carbure de silicium (SiC), carbure de titane (TiC), cordiérite (Al₃Mg₂AlSi₅O₁₈), mullite (Al₆Si₂O₁₃), nitrure d'aluminium (AIN), nitrure de bore (NB), alumine (Al₂O₃), borure d'aluminium (AlB₂), oxyde de magnésium (MgO), oxyde de zinc (ZnO), oxyde magnétique de fer (Fe₃O₄) zircone (Zr₂O), silice (Si₂O), fumées de silice, CaO, La₂CuO₄, La₂NiO₄, La₂SrCuO₄, Nd₂CuO₄, TiO₂, Y₂O₃, silicates d'aluminium (argiles).

4. Procédé selon l'une quelconque des revendications 1 à 3, dans lequel dans l'étape (i) le matériau est chauffé à une température allant de 700°C à 900°C, et plus avantageusement encore de 750°C à 850°C.

5. Procédé selon l'une quelconque des revendications 1 à 4, dans lequel dans l'étape (ii), l'acétylène est introduit dans l'enceinte réactionnelle sous forme de gaz en une quantité supérieure à 0 et allant jusqu'à 20% en volume du gaz total présent dans ladite enceinte.

6. Procédé selon l'une quelconque des revendications 1 à 5, dans lequel dans l'étape (ii), le xylène est introduit dans l'enceinte réactionnelle sous forme de micro gouttelettes via un spray.

7. Procédé selon l'une quelconque des revendications 1 à 6, dans lequel dans l'étape (ii), l'acétylène est introduit dans l'enceinte réactionnelle avec une vitesse linéaire de 5,0 x 10⁻⁶ à 1,0 x 10⁻¹ m/s et/ou dans lequel dans l'étape (ii), le xylène est introduit dans l'enceinte réactionnelle a un débit variant entre 0,1 et 0,7 ml/min.

8. Procédé selon l'une quelconque des revendications 1 à 7, dans lequel dans l'étape (iii), ledit renfort hybride est exposé à la source de carbone pendant une durée de 1 à 60 minutes selon l'épaisseur de la couche de carbone souhaitée.

9. Procédé selon l'une quelconque des revendications 1 à 8, dans lequel le procédé de renforcement de l'adhésion de NTC à la surface d'un matériau, est en continu.

10. Procédé selon l'une quelconque des revendications 1 à 9, dans lequel dans l'étape (iv), ledit renfort hybride, recouvert d'une couche de carbone, obtenu à l'issue de l'étape (iii) est récupéré éventuellement après une étape de refroidissement à une température comprise entre 15 et 150°C.

11. Procédé selon l'une quelconque des revendications 1 à 10, dans lequel les étapes (i) à (iv) sont réalisées sous un courant de gaz inerte(s) éventuellement en mélange avec de l'hydrogène avec un rapport hydrogène/gaz inerte(s) allant de 0/100 à 50/50.

12. Procédé selon l'une quelconque des revendications 1 à 11, dans lequel l'épaisseur de la couche de carbone est comprise entre 0,002 et 5 µm, avantageusement entre 2 et 250 nm.

13. Renfort hybride susceptible d'être obtenu par un procédé selon l'une quelconque des revendications 1 à 12, ledit renfort hybride se présente sous la forme (i) d'un renfort, comprenant à sa surface (ii) des NTC, ledit renfort et lesdits NTC étant recouverts d'une couche de carbone.

14. Renfort selon la revendication 13, ayant une prise de masse comprise entre 0 et 150% par rapport à la masse du matériau de départ.

15. Utilisation d'un renfort selon l'une des revendications 13 ou 14, pour la préparation de matériaux composites structuraux et fonctionnels.

16. Utilisation d'un renfort selon l'une des revendications 13 ou 14, pour la préparation de peintures ou vernis, de fils ou des bandes.

17. Procédé d'augmentation contrôlée du diamètre de NTC comprenant en outre les étapes du procédé tel que défini selon l'une quelconque des revendications 1 à 12.

18. Procédé selon la revendication 17, comprenant, préalablement aux étapes du procédé tel que défini selon l'une quelconque des revendications 1 à 12, une étape de croissance de NTC sur lesdits renforts par CVD en présence de catalyseur puis une étape de désactivation dudit catalyseur par un traitement thermique sous H₂.

## Patentansprüche

1. Verfahren zur Verstärkung der Adhäsion von Kohlenstoffnanoröhren an der Oberfläche eines Materials, was eine Hybridverstärkung bildet, wobei das Verfahren die folgenden Schritte umfasst, die unter einem Strom eines oder mehrerer Inertgase, gegebenenfalls im Gemisch mit Wasserstoff durchgeführt werden:
(i) Erhitzen der besagten Hybridverstärkung, die auf ihrer Oberfläche KNR umfasst, auf eine Temperatur von 500 °C bis 1100 °C in einem Reaktionsgefäß;
(ii) Einbringen einer Kohlenstoffquelle, die aus Acetylen und/oder Xylol besteht, in das besagte Gefäß in Abwesenheit eines Katalysators;
(iii) Aussetzen der besagten Hybridverstärkung, die für einen Zeitraum erhitzt wurde, der dazu ausreicht, um eine Kohlenstoffschicht mit einer kontrollierten Dicke auf der Oberfläche des besagten Materials und den dieses bedeckenden besagten KNR zu erhalten, gegenüber der Kohlenstoffquelle;
(iv) gegebenenfalls nach Kühlen Gewinnen der bei Abschluss des Schritts (iii) erhaltenen Hybridverstärkung, die mit einer Kohlenstoffschicht bedeckt ist und KNR umfasst, die von einer Kohlenstoffschicht umhüllt werden.

2. Verfahren nach Anspruch 1, wobei die Verstärkung in der besagten Hybridverstärkung in der Form von kurzen oder langen Fasern mit einem Durchmesser von 1 bis 100 µm, insbesondere Fasern mit einem Durchmesser von 4 bis 50 µm oder Partikeln mit einem Durchmesser von 0,1 bis 100 µm ist.

3. Verfahren nach einem der Ansprüche 1 oder 2, wobei das als Verstärkung verwendete Material aus der Gruppe bestehend aus Folgendem ausgewählt ist:
- Kohlenstoff-, Glas-, Aluminium-, Siliciumcarbid-(SiC), Steinwollefasern;
- Keramikmaterialien, die aus der Gruppe umfassend Partikel und/oder Fasern aus Siliciumnitrid (Si₃N₄), Borcarbid (B₄C), Siliciumcarbid (SiC), Titancarbid (TiC), Cordierit (Al₃Mg₂AlSi₅O₁₈) Mullit (Al₆Si₂O₁₃), Aluminiumnitrid (AlN), Bornitrid (NB), Aluminiumoxid (Al₂O₃), Aluminiumborid (AlB₂), Magnesiumoxid (MgO), Zinkoxid (ZnO), magnetischem Eisenoxid (Fe₃O₄), Zirconiumoxid (Zr₂O), Siliciumdioxid (Si₂O), Kieselsäuren, CaO, La₂CuO₄, La₂NiO₄, La₂SrCuO₄, Nd₂CuO₄, TiO₂, Y₂O₃, Aluminiumsilicaten (Tonen) ausgewählt sind.

4. Verfahren nach einem der Ansprüche 1 bis 3, wobei im Schritt (i) das Material auf eine Temperatur von 700 °C bis 900 °C und noch vorteilhafter 750 °C bis 850 °C erhitzt wird.

5. Verfahren nach einem der Ansprüche 1 bis 4, wobei im Schritt (ii) das Acetylen in das Reaktionsgefäß in Gasform in einer Menge von mehr als 0 und bis zu 20 Vol.-% des gesamten Gases, das in dem besagten Gefäß vorliegt, eingebracht wird.

6. Verfahren nach einem der Ansprüche 1 bis 5, wobei im Schritt (ii) das Xylol in das Reaktionsgefäß in der Form von Mikrotröpfchen mittels eines Sprühnebels eingebracht wird.

7. Verfahren nach einem der Ansprüche 1 bis 6, wobei im Schritt (ii) das Acetylen in das Reaktionsgefäß mit einer linearen Geschwindigkeit von 5,0 x 10⁻⁶ bis 1,0 x 10⁻¹ m/s eingebracht wird und/oder wobei im Schritt (ii) das Xylol in das Reaktionsgefäß mit einem Durchsatz, der zwischen 0,1 und 0,7 ml/min variiert, eingebracht wird.

8. Verfahren nach einem der Ansprüche 1 bis 7, wobei im Schritt (iii) die besagte Hybridverstärkung gegenüber der Kohlenstoffquelle für einen Zeitraum von 1 bis 60 Minuten gemäß der gewünschten Dicke der Kohlenstoffschicht ausgesetzt wird.

9. Verfahren nach einem der Ansprüche 1 bis 8, wobei das Verfahren zur Verstärkung der Adhäsion von KNR an der Oberfläche eines Materials ein kontinuierliches Verfahren ist.

10. Verfahren nach einem der Ansprüche 1 bis 9, wobei im Schritt (iv) die besagte zum Abschluss des Schritts (iii) erhaltene Hybridverstärkung, die mit einer Kohlenstoffschicht bedeckt ist, gegebenenfalls nach einem Kühlschritt bei einer Temperatur zwischen 15 und 150 °C gewonnen wird.

11. Verfahren nach einem der Ansprüche 1 bis 10, wobei die Schritte (i) bis (vi) unter einem Strom eines oder mehrerer Inertgase, gegebenenfalls im Gemisch mit Wasserstoff in einem Verhältnis von Wasserstoff zu inertem Gas bzw. inerten Gasen von 0:100 bis 50:50 durchgeführt werden.

12. Verfahren nach einem der Ansprüche 1 bis 11, wobei die Dicke der Kohlenstoffschicht zwischen 0,002 und 5 µm, vorteilhaft zwischen 2 und 250 nm liegt.

13. Hybridverstärkung, die durch ein Verfahren nach einem der Ansprüche 1 bis 12 erhalten werden kann, wobei die besagte Hybridverstärkung in der Form (i) einer Verstärkung ist, die auf ihrer Oberfläche (ii) KNR umfasst, wobei die besagte Verstärkung und die besagten KNR mit einer Kohlenstoffschicht bedeckt sind.

14. Verstärkung nach Anspruch 13, die eine Massezunahme zwischen 0 und 150 % in Bezug auf die Masse des Ausgangsmaterials aufweist.

15. Verwendung einer Verstärkung nach einem der Ansprüche 13 oder 14 zur Herstellung von strukturellen und funktionellen Verbundmaterialien.

16. Verwendung einer Verstärkung nach einem der Ansprüche 13 oder 14 zur Herstellung von Farben oder Lacken, Fäden oder Streifen.

17. Verfahren zur kontrollierten Erhöhung des Durchmessers von KNR, das außerdem die Schritte des wie in einem der Ansprüche 1 bis 12 definierten Verfahrens umfasst.

18. Verfahren nach Anspruch 17, das vor den Schritten des wie in einem der Ansprüche 1 bis 12 definierten Verfahrens einen Schritt des Wachsens von KNR auf den besagten Verstärkungen durch CVD in Gegenwart eines Katalysators und dann einen Schritt des Desaktivierens des besagten Katalysators durch eine Wärmebehandlung unter H₂ umfasst.

## Claims

1. Method for strengthening the adhesion of carbon nanotubes at the surface of a material constituting a hybrid reinforcement, comprising the following steps carried out under a stream of inert gas(es), optionally as a mixture with hydrogen:
(i) heating in a reaction chamber said hybrid reinforcement comprising CNTs at its surface, at a temperature ranging from 500°C to 1100°C;
(ii) introducing into said chamber, a carbon source consisting of acetylene and/or xylene, in the absence of catalyst;
(iii) exposing said hybrid reinforcement to the carbon source, heated for a period of time sufficient to obtain a carbon layer of controlled thickness at the surface of said material and said CNTs covering it;
(iv) recovering, optionally after cooling, said reinforcement obtained in conclusion of step (iii), covered with a carbon layer and comprising CNTs sheathed with a carbon layer.

2. Method according to claim 1, in which the reinforcement in said hybrid reinforcement is provided in the form of short of long fibers with a diameter from 1 to 100 µm, in particular of fibers with a diameter from 4 to 50 µm, or of particles with a diameter from 0.1 to 100 µm.

3. Method according to either one of claim 1 or 2, in which the material used as reinforcement is chosen from the group comprising:
- carbon, glass, alumina, silicon carbide (SiC), rock fibers;
- ceramic materials chosen from the group comprising particles and/or fibers of silicon nitride (Si₃N₄), boron carbide (B₄C), silicon carbide (SiC), titanium carbide (TiC), cordierite (Al₃Mg₂AlSi₅O₁₈), mullite (Al₆Si₂O₁₃) aluminum nitride (AlN), boron nitride (BN), alumina (Al₂O₃), aluminum boride (AlB₂), magnesium oxide (MgO), zinc oxide (ZnO), magnetic iron oxide (Fe₃O₄), zirconia (Zr₂O), silica (SiO₂), fumed silica, CaO, La₂CuO₄, La₂NiO₄, La₂SrCuO₄, Nd₂CuO₄, TiO₂, Y₂O₃, aluminum silicates (clays).

4. Method according to any one of claims 1 to 3, in which, in step (i), the material is heated to a temperature ranging from 700°C to 900°C and more advantageously still from 750°C to 850°C.

5. Method according to any one of claims 1 to 4, in which, in step (ii), the acetylene is introduced into the reaction chamber in the gas form in an amount greater than 0 and ranging up to 20% by volume of the total gas present in said chamber.

6. Method according to any one of claims 1 to 5, in which, in step (ii), the xylene is introduced into the reaction chamber in the form of microdroplets via a spray.

7. Method according to any one of claims 1 to 6, in which, in step (ii), the acetylene is introduced into the reaction chamber with a linear velocity of 5.0 × 10⁻⁶ to 1.0 × 10⁻¹ m/s and/or in which, in step (ii), the xylene is introduced into the reaction chamber at a flow rate varying between 0.1 and 0.7 ml/min.

8. Method according to any one of claims 1 to 7, in which, in step (iii), said hybrid reinforcement is exposed to the carbon source for a period of time of 1 to 60 minutes, depending on the desired thickness of the carbon layer.

9. Method according to any one of claims 1 to 8, in which the method for strengthening the adhesion of CNTs at the surface of a material is a continuous method.

10. Method according to any one of claims 1 to 9, in which, in step (iv), said hybrid reinforcement covered with a carbon layer, obtained on conclusion of step (iii), is optionally recovered after a step of cooling to a temperature of between 15 and 150°C.

11. Method according to any one of claims 1 to 10, in which steps (i) to (iv) are carried out under a stream of inert gas(es), optionally in a mixture with hydrogen, with a hydrogen/inert gas(es) ratio ranging from 0/100 to 50/50.

12. Method according to any one of claims 1 to 11, in which the thickness of the carbon layer is between 0.002 and 5 µm, advantageously between 2 and 250 nm.

13. Hybrid reinforcement capable of being obtained by a method according to any one of claims 1 to 12, said hybrid reinforcement being provided in the form (i) of a reinforcement comprising, at its surface, (ii) CNTs, said reinforcement and said CNTs being covered with a carbon layer.

14. Reinforcement according to claim 13, having an increase in weight of between 0% and 150%, with respect to the weight of the original material.

15. Use of a reinforcement according to either one of claim 13 or 14, in the preparation of structural and functional composite materials.

16. Use of a reinforcement according to either one of claim 13 or 14, in the preparation of paints or varnishes, threads or strips.

17. Method for the controlled enhancement of the diameter of CNTs additionally comprising the steps of the method as defined according to any one of claims 1 to 12.

18. Method according to claim 17, comprising, prior to the steps of the method as defined according to any one of claims 1 to 12, a step of growth of CNTs on said reinforcements by CVD in the presence of catalyst and then a step of deactivation of said catalyst by a heat treatment under H₂.
